# EUROPÄISCHE PATENTSCHRIFT

(11) **EP 2 688 857 B1**
(45) Veröffentlichungstag und Bekanntmachung des Hinweises auf die Patenterteilung: **31.08.2016**
(21) Anmeldenummer: 12710678.9
(22) Anmeldetag: 14.03.2012
(51) Int. Cl.: C04B 38/00, H01M 4/1393, C03B 37/005, C03B 19/14

(54) **VERFAHREN FÜR DIE HERSTELLUNG PORÖSER GRANULATTEILCHEN AUS ANORGANISCHEM WERKSTOFF**
METHOD FOR PRODUCING POROUS GRANULES FROM INORGANIC MATERIAL
PROCÉDÉ DE PRODUCTION DE PARTICULES GRANULÉES POREUSES D'UN MATÉRIAU INORGANIQUE

(30) Priorität: 23.03.2011 DE 102011014875
(43) Veröffentlichungstag der Anmeldung: 29.01.2014
(73) Patentinhaber: Heraeus Quarzglas GmbH & Co. KG, 63450 Hanau (DE)
(72) Erfinder: NEUMANN, Christian, 35410 Hungen (DE); BECKER, Jörg, 61194 Niddatal (DE); HOFMANN, Achim, 60599 Frankfurt (DE)
(74) Vertreter: Staudt, Armin Walter
(86) Internationale Anmeldenummer: PCT/EP2012/054442
(87) Internationale Veröffentlichungsnummer: WO 2012/126782

(56) Entgegenhaltungen:
- EP-A1- 1 813 574
- WO-A1-2008/136924
- WO-A2-2011/092149
- MBILENI C N ET AL: "Synthesis of mesoporous carbon supports via liquid impregnation of polystyrene onto a MCM-48 silica template", CARBON, ELSEVIER, OXFORD, GB, Bd. 44, Nr. 8, 1. Juli 2006 (2006-07-01), Seiten 1476-1483, XP025010841, ISSN: 0008-6223, DOI: 10.1016/J.CARBON.2005.12.012 [gefunden am 2006-07-01]

## Beschreibung

Die Erfindung betrifft ein Verfahren für die Herstellung poröser Granulatteilchen aus anorganischem Werkstoff.

Granulatteilchen mit innerer Porosität bestehen aus Agglomeraten oder Aggregaten von Primärpartikeln aus Oxiden, Nitriden, Carbiden oder Boriden. Als Beispiel seien Siliziumdioxid, Zinnoxid und Titannitrid genannt. Die Primärpartikel fallen beispielsweise bei der Synthese durch Polymerisation, Polykondensation, Fällung oder CVD-Abscheideverfahren an, wie sie beispielsweise für die Herstellung von synthetischem Quarzglas bekannt ist. Wegen ihrer geringen Schüttdichte sind die Primärpartikel schwierig handhabbar, und sie werden in der Regel anhand Aufbau- oder Pressgranulierungsverfahren verdichtet. Als Beispiele seien die Rollgranulation in einem Granulierteller, Sprühgranulation, Zentrifugalzerstäubung, Wirbelschichtgranulation, Granulierverfahren unter Einsatz einer Granuliermühle, Kompaktierung, Walzenpressen, Brikettierung, Schülpenherstellung oder Extrudierung genannt.

Die dabei diskreten, mechanisch und gegebenenfalls auch thermisch vorverdichteten porösen Granulatteilchen setzen sich somit aus einer Vielzahl von Primärpartikeln zusammen. In ihrer Gesamtheit bilden sie das "Granulat".

### Stand der Technik

In der DE 102 43 953 A1 wird ein typisches Aufbau-Granulationsverfahren beschrieben, bei dem lockeres, pyrogen hergestelltes SiO₂-Pulver (so genannter "Sootstaub"), wie es als Filterstaub bei der Quarzglasherstellung anfällt, in Wasser eingemischt und so eine Suspension erzeugt wird. Diese wird mittels eines Nassgranulierverfahrens zu SiO₂-Granulatkörnern verarbeitet, die nach dem Trocknen und Reinigen durch Erhitzen in chlorhaltiger Atmosphäre thermisch verdichtet und dabei bis zu transparenter Quarzglaskörnung mit Körnungsdurchmessern um 140 µm gesintert werden.

Die WO 2007/085511 A1 beschreibt ein Granulationsverfahren, bei dem feinteiliges Ausgangspulver mechanisch - auch unter Zusatz von Gleit- oder Bindemitteln - durch Walzenkompaktierung zu gröberen Teilchen agglomeriert und durch mechanischen Druck verdichtet wird. Dabei wird feinteiliges Kieselsäurepulver zwischen gegenläufig rotierenden Walzen, die glatt oder profiliert sein können, hindurchgeführt, und dabei zu SiO₂-Granulat verdichtet, das in Form sogenannter "Schülpen" anfällt. Diese bilden mehr oder weniger bandförmige Gebilde, die normalerweise gebrochen und nach Größe klassifiziert werden. Die Schülpen-Bruchstücke können bei einer Temperatur im Bereich von 400 bis 1100° in einer halogenhaltigen Atmosphäre getrocknet und im Bereich von 1200 °C bis 1700 °C zu einem "Kieselglasgranulat" dicht gesintert werden.

Die bekannten Granulationsverfahren gehen von feinteiligem Pulver aus, wie etwa von SiO₂-Sootpulver. Dieses wird anhand weiterer Verfahrensschritte, die zum Teil langwierig sind und mit einem hohen Energiebedarf einhergehen, weiterverarbeitet. Die so erhaltenen Granulat-Teilchen haben oftmals eine sphärische Morphologie. Eine nach dem mechanischen und/oder thermischen Verdichten verbleibende innere Porosität des Granulats hängt von verdichtungsrelevanten Eigenschaften des pulverförmigen Ausgangsmaterials und dem jeweiligen Granulationsprozess ab.

Das poröse Granulat wird beispielsweise als Füllstoff oder zur Herstellung von opakem Quarzglas eingesetzt. Als Halbzeug zur Herstellung von Elektrodenmaterial wiederaufladbarer Lithium-Batterien ist es jedoch nicht uneingeschränkt geeignet.

Im Elektrodenmaterial wiederaufladbarer Lithium-Batterien soll Lithium bei geringem Ladungsverlust reversibel ein- und ausgelagert werden können. Dafür wird eine hohe Porosität (Durchlässigkeit) bei gleichzeitig möglichst geringer Oberfläche des Elektrodenmaterials angestrebt. Dazu trägt eine spezifische Art der inneren Porosität bei, die als "hierarchische Porosität" bekannt ist, und bei der Poren im Nanometerbereich über ein durchgängiges makroporöses Transportsystem miteinander verbunden sind, was die Zugänglichkeit zu diesen Poren von außen erhöht.

Die Herstellung eines Halbzeugs mit geeigneter innerer Porenstruktur ist aus der US 2005/0169829 A1 bekannt. Dabei wird eine Dispersion aus Siliziumdioxidkügelchen mit Durchmessern von 800 nm bis 10 µm und einer polymerisierbaren Substanz in einer Form erhitzt, so dass durch Polymerisation ein poröses SilicaGel erhalten wird, das nach dem Entfernen der überschüssigen Flüssigkeit getrocknet und vollständig auspolymerisiert wird.

Dieses Material dient als sogenanntes "Templat" zur Herstellung eines monolithischen Kohlenstofferzeugnisses mit hierarchischer Porenstruktur aus Makroporen und Mesoporen. Hierzu werden die Poren des SiO₂-Templats mit einer Vorläufersubstanz für Kohlenstoff imprägniert, die Kohlenstoffvorläufersubstanz zu Kohlenstoff karbonisiert und das SiO₂-Templat anschließend durch Lösen in HF oder NaOH entfernt.

Diese Art der Herstellung des SiO₂-Templats erfordert einen hohen Zeit- und Materialaufwand, was insbesondere für Anwendungen für Massenartikel wie etwa Sekundärbatterien, bei denen es auf geringe Herstellkosten ankommt, nicht akzeptabel ist.

### Technische Aufgabenstellung

Der Erfindung liegt die Aufgabe zugrunde, ein Verfahren anzugeben, das eine kostengünstige und gleichzeitig reproduzierbarere Herstellung von porösem Granulat ermöglicht, das eine stärkere Ausprägung einer hierarchischen Porenstruktur aufweist.

### Allgemeine Darstellung der Erfindung

Diese Aufgabe wird erfindungsgemäß durch ein Verfahren gelöst, das die folgenden Verfahrensschritte umfasst:
(a) Zuführen eines Einsatzmaterial-Stroms zu einer Reaktionszone, in der das Einsatzmaterial durch Pyrolyse oder durch Hydrolyse zu Werkstoff-Partikeln umgesetzt wird,
(b) Abscheiden der Werkstoff-Partikel auf einer Ablagerungsfläche unter Bildung einer Sootschicht,
(c) thermisches Verfestigen der Sootschicht zu einer porösen Sootplatte,
(d) Zerkleinern der Sootplatte zu den porösen Granulatteilchen.

Das erfindungsgemäße Verfahren umfasst einen Sootabscheideprozess. Dabei wird eine flüssige oder gasförmige Ausgangssubstanz einer chemischen Reaktion (Hydrolyse oder Pyrolyse) unterzogen und aus der Gasphase als Feststoffkomponente auf einer Ablagerungsfläche abgeschieden. Die Reaktionszone ist beispielsweise eine Brennerflamme oder ein Lichtbogen (Plasma). Mittels derartiger Plasma- oder CVD-Abscheideverfahren, die beispielsweise unter den Bezeichnungen OVD-, VAD-, POD-Verfahren bekannt sind, werden im industriellen Maßstab synthetisches Quarzglas, Zinnoxid, Titannitrid und andere synthetische Werkstoffe hergestellt.

Bei der Ablagerungsfläche handelt es sich beispielsweise um ein Gefäß, einen Dorn, eine Zylindermantelfläche, eine Platte oder einen Filter. Der darauf abgeschiedene poröse Ruß (hier als "Soot" bezeichnet) fällt in Form einer Sootschicht an. Deren Porosität wird gewährleistet, indem die Temperatur der Ablagerungsfläche so niedrig gehalten wird, dass ein Dichtsintern des abgeschiedenen Werkstoffs verhindert wird.

In der Reaktionszone entstehen Primärpartikel mit Partikelgrößen im Nanometerbereich, die sich auf ihrem Weg zur Ablagerungsfläche in Form mehr oder weniger sphärischer Agglomerate oder Aggregate zusammenlagern. Je nach Grad der Wechselwirkung mit der Reaktionszone auf ihrem Weg zur Ablagerungsfläche lagert sich eine unterschiedliche Anzahl von Primärpartikeln zusammen, so dass grundsätzlich eine breite Teilchengrößenverteilung im Bereich von etwa 5 nm bis etwa 200 nm ergibt. Innerhalb der Aggregate und Agglomerate - zwischen den Primärpartikeln - liegen besonders kleine Hohlräume und Poren im Nanometerbereich vor, also so genannte Mesoporen, wohingegen sich zwischen den einzelnen Aggregaten und Agglomeraten größere Hohlräume oder Poren ausbilden, die in der thermisch verfestigten Sootplatte und in Teilstücken derselben ein System miteinander verbundener Makroporen bilden. Diese innere Porenstruktur mit oligomodaler Porengrößenverteilung ist charakteristisch für die gewünschte "hierarchische Porosität" des porösen Werkstoffs. Mittels des Sootabscheideprozesses wird somit eine anisotrope Masseverteilung mit hierarchischer Porenstruktur erzeugt.

Eine gewisse thermische Verfestigung der Sootschicht zu einer porösen Sootplatte ist erwünscht. Die thermische Verfestigung wird erreicht, indem die Sootschicht entweder beim Abscheideprozess oder alternativ dazu oder ergänzend dazu in einem an den Abscheideprozess anschließenden separaten Heizprozess teilweise gesintert wird. Ziel der thermischen Verfestigung ist eine poröse Sootplatte mit einer gewissen mechanischen Stabilität, die ausreicht, beim anschließenden Zerkleinern der Sootplatte solche Granulatteilchen zu erhalten, die reproduzierbar größer sind als die Primärpartikel, und deren Abmessungen mindestens in Dickenrichtung der Platte definiert klein ist. Diese Abmessungen der Granulatteilchen sind für Infiltrationsvorgänge vorteilhaft, wenn es auf hohe Homogenität der Infiltrierung ankommt, wie weiter unten noch näher erläutert wird.

Vor dem Zerkleinern der verfestigten porösen Sootplatte wird diese von der Ablagerungsfläche abgenommen. Alternativ erfolgt das Zerkleinern der Sootplatte zu den porösen Granulatteilchen unmittelbar auf der Ablagerungsfläche.

Wegen ihrer relativ geringen mechanischen Festigkeit genügen zum Zerkleinern der Sootplatte zu den porösen Granulatteilchen geringe Kräfte. Das Zerkleinern geschieht durch Schneiden oder Brechen der Sootplatte. Auch das Brechen führt zu Granulatteilchen mit relativ schmaler Teilchengrößenverteilung, denn die Abmessung der Granulatteilchen in Richtung der Sootplatte gesehen ist durch deren Dicke limitiert. Die entsprechende Abmessung der Granulatteilchen entspricht im einfachsten Fall der Dicke der Sootplatte; sie kann auch kleiner sein als, besonders dann, wenn die Sootplatte wegen eines schichtweisen Aufbaus leicht delaminiert. Eine enge Teilchengrößenverteilung ist insbesondere für Anwendungen vorteilhaft, bei denen die Granulatteilchen innerhalb möglichst kurzer Zeit von außen mit einer flüssigen oder gasförmigen Substanz homogen infiltriert werden müssen.

Das Sootabscheideverfahren ermöglicht im Vergleich zu den eingangs erläuterten Herstellungsverfahren die kostengünstige Herstellung von porösen Soot-Granulatteilchen im industriellen Maßstab, die sich durch eine hierarchische Porenstruktur auszeichnen.

Es hat sich bewährt, wenn eine Sootplatte mit einer Dicke im Bereich von 10 bis 500 µm, vorzugsweise im Bereich von 20 bis 100 µm, besonders bevorzugt weniger als 50 µm erzeugt wird.

Die Dicke der Sootplatte bestimmt die Maximaldicke der Granulatteilchen. Diese können dünner als die Sootplatte sein aber nicht dicker. In der Regel stellt diese Abmessung der Granulatteilchen - begrenzt von einer im Wesentlichen planen Oberseite und einer im Wesentlichen planen Unterseite - gleichzeitig deren minimale Abmessung dar. Etwaige zeitabhängige Infiltrationsprozesse, die über die Oberseite und/oder die Unterseite ablaufen, benötigen daher nur eine geringe Dauer zur optimal homogenen Durchdringung des Granulatteilchens. Bei Granulatteilchen einer Dicke von mehr als 500 µm lässt dieser Vorteil nach und Granulatteilchen von weniger als 10 µm sind mechanisch wenig stabil und erschweren die Ausbildung einer ausgeprägten hierarchischen Porenstruktur.

Die durch Sootabscheidung erzeugte und thermisch verdichtete Sootplatte kann mit geringem Aufwand zerkleinert werden, wobei Granulatteilchen mit plättchenartiger oder flockenartigen Morphologie erhalten werden. Diese zeichnen sich somit durch eine nicht sphärische Morphologie aus, die besonders homogen und schnell infiltriert werden kann.

Denn Partikel mit sphärischer Morphologie, also Partikel mit einer Kugelform oder annähernd kugelförmiger Morphologie zeigen eine geringe Oberfläche in Bezug auf ihr Volumen. Demgegenüber zeigen Granulatteilchen mit nicht sphärischer Morphologie ein größeres Verhältnis von Oberfläche zu Volumen, was die Infiltration mit einer flüssigen Substanz vereinfacht und vergleichmäßigt.

Als besonders vorteilhaft in dieser Hinsicht erweisen sich Granulatteilchen, die plättchenförmig oder stäbchenförmig mit einem Strukturverhältnis von mindestens 5, vorzugsweise von mindestens 10 ausgebildet sind.

Unter dem "Strukturverhältnis" wird hierbei das Verhältnis von größter Strukturbreite des Granulatteilchens und seiner Dicke verstanden. Ein Strukturverhältnis von mindestens 5 bedeutet demnach, dass die größte Strukturbreite eines Granulatteilchens mindestens 5-mal größer ist als seine Dicke. Derartige Granulatteilchen haben Plättchen- oder Stäbchenform und zeichnen sich durch zwei im Wesentlichen parallel verlaufende große Oberflächen mit offenen Poren aus, über die das Infiltrieren einer flüssigen Substanz relativ schnell erfolgen kann, da die Dicke des aufzufüllenden Volumens vergleichsweise gering ist.

Dazu trägt bei, wenn die Granulatteilchen seitlich Bruchflächen mit offenen Poren aufweisen.

Denn ein Infiltrieren einer flüssigen Substanz kann bei dieser Ausführungsform der Granulatteilchen auch über deren offene seitliche Bruchflächen erfolgen.

Je geringer die Dicke der Granulatteilchen ist, umso einfacher und homogener erfolgt eine etwaige Infiltration. Im Hinblick hierauf hat es sich als vorteilhaft erwiesen, wenn die Granulatteilchen eine mittlere Dicke im Bereich von 10 µm bis 500 µm, vorzugsweise im Bereich von 20 µm bis 100 µm, besonders bevorzugt weniger als 50 µm aufweisen.

Granulatteilchen mit einer Dicke von weniger als 10 µm haben eine geringe mechanische Festigkeit und erschweren die Ausbildung einer ausgeprägten hierarchischen Porenstruktur. Bei Dicken von mehr als 500 µm wird es zunehmend schwierig, eine homogene Infiltration zu gewährleisten.

Zur Minimierung der Produktionskosten wird eine kontinuierliche Herstellung der Granulatteilchen angestrebt. Hierzu kann die Ablagerungsfläche beispielsweise als umlaufende Förderbahn ausgebildet sein. Besonders bewährt hat es sich auch, wenn die Ablagerungsfläche als Zylindermantelfläche einer um eine Rotationsachse drehenden Trommel ausgebildet ist.

Die Trommel hat im einfachsten Fall einen runden Querschnitt; sie kann als Vollzylinder oder Hohlzylinder ausgeführt sein. Ihre Oberfläche besteht vorzugsweise aus einem Werkstoff, der sich mit dem Werkstoff der Sootschicht bei der gegebenen Abscheide- und Verdichtungstemperatur nicht verbindet und so das Abnehmen der Sootschicht erleichtert. Sie kann aus mehreren Werkstoffen bestehen, wie etwa einem metallischen Innenmantel, der von einem keramischen Außenmantel zum Schutz vor korrosiven Einflüssen umgeben ist.

Aus der WO 2008/136924 A1 ist ein Verfahren zur Herstellung einer Quarzglasplatte bekannt. Dabei werden mittels mehrerer Flammhydrolysebrenner SiO₂-Sootpartikel erzeugt und auf der Zylindermantelfläche einer um ihre Mittelache rotierenden Trommel als Sootschicht mit einer Dichte im Bereich von 0,8 bis 1,25 g/cm³ abgeschieden. Die Sootschicht wird von der Trommel abgenommen und unmittelbar einer Heizzone zugeführt und darin zu einer Quarzglasplatte mit einer Dicke zwischen 10 und 40 µm verglast. Die aus dieser Druckschrift bekannte Vorrichtung ist auch zur Herstellung von porösem Granulat anhand des erfindungsgemäßen Verfahrens geeignet.

Vorzugsweise ist der Durchmesser der Trommel so groß, dass die Sootschicht nach weniger als einer Umdrehung der Trommel um die Rotationsachse vollständig ausgebildet ist.

Dies vereinfacht das Abnehmen der Sootschicht von der Zylindermantelfläche der Trommel.

Insbesondere im Hinblick auf eine schnelle und eine homogene Ausbildung der Sootschicht bei nur einer Umdrehung der Trommel hat sich eine Verfahrensvariante als günstig erwiesen, bei der die Bildung der Sootschicht mittels einer Anordnung von Abscheidebrennern erfolgt, die entlang der Rotationsachse reversierend bewegt wird.

Die Abscheidebrenner sind dabei in einem festen Abstand zueinander in einer Reihe oder versetzt zueinander auf einer gemeinsamen Brennerbank montiert, die über eine Strecke, die kürzer ist als die Breite der Ablagerungsfläche hin- und herbewegt wird. Es sind eine oder mehrere derartige Brennerreihen vorgesehen.

Alternativ dazu und gleichermaßen bevorzugt im Hinblick auf eine wirtschaftliche Verfahrensweise und eine homogene Ausbildung der Sootschicht erfolgt deren Ausbildung mittels eines ortsfesten Linearbrenners, dessen Längsachse sich entlang der Trommel erstreckt.

Der Linearbrenner erzeugt unmittelbar nebeneinander mehrere Brennerflammen in einer Flammenreihe, die sich über die Breite der Ablagerungsfläche erstreckt. Es sind eine oder mehrere derartiger Flammenreihen vorgesehen.

Im einfachsten Fall erfolgt das thermische Verdichten des Sootschicht zur Sootplatte unmittelbar beim Abscheideprozess der Sootpartikel durch Erhitzen mittels des oder der Abscheidebrenner. Dadurch kann die Oberflächentemperatur im Bereich der Sootschicht so eingestellt werden, dass sich eine hinreichende Verdichtung einstellt. Das thermische Verdichten der Sootschicht gemäß Verfahrensschritt (c) kann aber auch vorteilhaft ein Beheizen mittels mindestens eines Zusatzbrenners umfassen.

Durch Einsatz eines oder mehrerer Zusatzbrenner zur Verdichtung können der oder die Abscheidebrenner an den Abscheideprozess und der Zusatzbrenner an die Verdichtungsaufgabe optimal angepasst werden.

Es hat sich bewährt, wenn die Ablagerungsfläche auf einem Hohlkörper ausgebildet ist, der von Innen temperiert wird.

Durch Heizen oder Kühlen der Ablagerungsfläche können die Effektivität des Abscheideprozesses, der Grad der Verdichtung oder das Abnehmen der Sootschicht optimiert werden.

Es hat sich als günstig erwiesen, wenn die Sootplatte eine relative Dichte - bezogen auf die spezifische Maximaldichte des Werkstoffs - im Bereich von 10 % bis 40 %, vorzugsweise weniger als 25%, aufweist.

Je geringer die mittlere Dichte der Sootplatte ist, umso größer ist das zur Verfügung stehende Porenvolumen und umso geringer sind Materialverlust und Aufwand zum Entfernen des Werkstoffs beim Einsatz als Templatmaterial. Bei Dichten von weniger als 10 % ergibt sich jedoch eine geringe mechanische Stabilität, was Handhabung und Einsatz des Granulats erschwert. Die Dichte der porösen Sootplatte wird beispielsweise durch die Oberflächentemperatur beim Sootabscheideprozess, durch die Temperatur bei einem separaten Verdichtungsvorgang und/oder durch Aufbringen von mechanischem Druck auf die Sootschicht eingestellt.

Die Sootplatte wird zum Zerkleinern gemäß Verfahrensschritt (d) bevorzugt von der Ablagerungsfläche abgenommen und dabei von der Unterseite der Sootplatte mit einem Gasstrom angeblasen.

Mittels des Gasstroms wird die Sootplatte kontinuierlich von der Unterlage abgehoben und dem Zerkleinerungsprozess zugeführt. Diese Verfahrensweise zum Abnehmen von Gut von einem Transportband ist unter der Bezeichnung "Air Knife" oder "Air Blade" allgemein bekannt.

Dabei hat sich als günstig erwiesen, wenn das Zerkleinern der Sootplatte gemäß Verfahrensschritt (d) in einer Zone erfolgt, die von der Ablagerungsfläche räumlich mindestens teilweise getrennt ist.

Dadurch wird der Eintrag von Staub aus dem Zerkleinerungsprozess in den Bereich der Abscheidung vermindert.

Das Zerkleinern der Sootplatte erfolgt vorzugsweise durch Brechen oder Schneiden.

Da die Sootplatte mechanisch wenig stabil ist, kann das Zerkleinern auf einfache Weise durch Brechen oder Schneiden bewirkt werden. Beispielsweise genügt es, die Sootplatte zwischen profilierten Rollen hindurchzuführen um sie zu brechen. Im Gegensatz zu Mahlverfahren, bei denen leicht Verunreinigungen durch Abrieb mechanischer Mahlwerkzeuge in das Mahlgut eingetragen werden können und die in der Regel zu einer breiten Teilchengrößenverteilung führen, ist die Gefahr des Eintrags von Verunreinigungen beim Brechen und Schneiden gering, und insbesondere zeigen die gebrochenen oder geschnittenen Granulatteilchen reproduzierbar eine enge Teilchengrößenverteilung.

Bei dem anorganischen Werkstoff handelt es sich bevorzugt um SiO₂. Synthetisches SiO₂ ist mittels Sootabscheideverfahren unter Einsatz preiswerter Ausgangssubstanzen im industriellen Maßstab relativ kostengünstig herstellbar.

Sootschichten aus synthetisch erzeugtem anorganischem Werkstoff, insbesondere aus SiO₂, zeichnen sich durch eine gute thermische Beständigkeit und durch eine anisotrope Porenverteilung aus, die diese unmittelbar für einen Einsatz als Templatmaterial für die Herstellung von porösem Kohlenstoffflocken oder - plättchen geeignet macht. Die dabei erhaltenen Kohlenstoffflocken oder - plättchen geeignet macht. Die dabei erhaltenen Kohlenstoffflocken oder - plättchen bestehen aus einem porösen Kohlenstoffgerüst mit schichtförmiger Morphologie und hierarchischer Porenstruktur. Diese stellt sich aufgrund der Herstellung der der Granulatteilchen durch Gasphasenabscheidung ein, wie oben anhand des erfindungsgemäßen Verfahrens näher erläutert.

### Ausführungsbeispiel

Nachfolgend wird die Erfindung anhand von Ausführungsbeispielen und einer Zeichnung näher erläutert. Im Einzelnen zeigt in schematischer Darstellung
- **Figur 1**: eine Vorrichtung zur Herstellung von SiO₂-Granulatteilchen,
- **Figur 2**: ein SiO₂-Granulatteilchen in vergrößerter Darstellung.

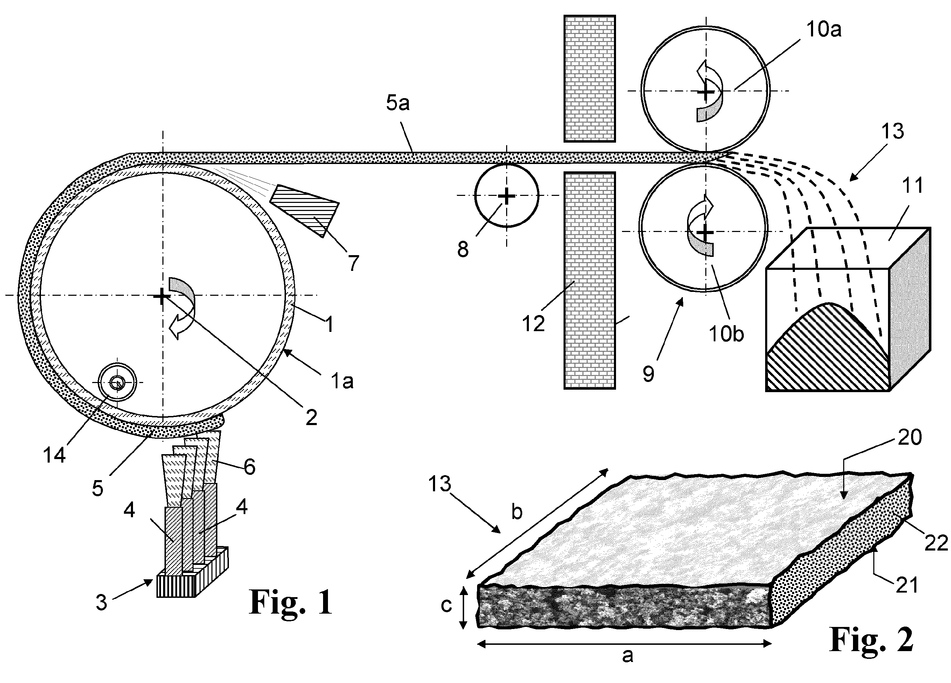

Die in **Figur 1** dargestellte Vorrichtung dient zur Herstellung poröser Granulatteilchen aus SiO₂. Sie umfasst eine um ihre Rotationsachse 2 rotierbare Trommel 1, die aus einem Grundkörper aus Edelstahl besteht, der mit einer dünnen Schicht aus Siliciumcarbid belegt ist. Die Trommel 1 hat einen Außendurchmesser von 30 cm und eine Breite von 50 cm. Auf der Mantelfläche 1a der Trommel 1 wird eine Schicht 5 aus SiO₂-Soot abgeschieden und unmittelbar zu einer SiO₂-Sootplatte 5a verglast.

Für die Sootabscheidung werden Flammhydrolysebrenner 4 eingesetzt, von denen vier in einer gemeinsamen Brennerreihe 3 in Richtung der Trommel-Längsachse 2 hintereinander angeordnet sind. Die Brennerreihe 3 wird parallel zur Rotationsachse 2 zwischen zwei ortsfesten Wendepunkten hin- und her bewegt. Den Flammhydrolysebrennern 4 werden als Brenngase Sauerstoff und Wasserstoff sowie Octamethylcyclotetrasiloxan (OMCTS) als Einsatzmaterial für die Bildung von SiO₂-Partikeln zugeführt. Die Größe der dabei erzeugten SiO₂-Primärpartikel liegt im Nanometerbereich, wobei sich mehrere Primärpartikel in der Brennerflamme 6 zusammenlagern und in Form mehr oder weniger sphärischer Aggregate mit einer spezifischen Oberfläche nach BET im Bereich von 50 m²/g anfallen, die auf der Trommel-Mantelfläche 1 a eine durchgängige, gleichmäßig dicke SiO₂-Sootschicht 5 bilden.

Im Ausführungsbeispiel werden die Rotationsgeschwindigkeit der Trommel 1 und die Abscheiderate der Flammhydrolysebrenner 4 so abgestimmt, dass sich eine SiO₂-Sootschicht 5 mit einer Breite von etwa 40 cm und einer Dicke von etwa 45 µm ergibt (die Sootschicht ist in Figur 1 aus Darstellungsgründen übertrieben dick eingezeichnet). Die Brenner 4 bewirken gleichzeitig ein gewisses Vorsintern der Sootschicht 5 zu einer Sootplatte 5a, indem sie auf der Oberfläche der obersten Sootlage eine mittlere Temperatur von etwa 1200°C erzeugt. Unterstützt wird das Vorsintern von einem rohrförmigen Infrarotstrahler 14, der innerhalb der als Hohltrommel ausgebildeten Trommel 1 im linken unteren Quadranten angeordnet ist, und der die Mantelfläche der Trommel 1 kurz nach dem Aufbringen der Sootschicht 5 von der Innenseite aus erhitzt.

Die so erhaltene poröse, leicht vorgesinterte Sootplatte 5a hat eine mittlere relative Dichte von etwa 22 % (bezogen auf die Dichte von Quarzglas mit 2,21 g/m³).

Nach etwas mehr als einer halben Trommel-Umdrehung gelangt die Sootplatte 5a in den Einwirkungsbereich eines Gebläses 7, mittels dem ein gegen die Unterseite der Sootplatte 5a gerichteter Gasstrom erzeugt wird, so dass sich die Sootplatte 5a von der Trommel-Mantelfläche 1 a abhebt.

Die Sootplatte 5a wird anschließend über eine Stützrolle 8 einem Brechwerkzeug 9 zugeführt, das aus zwei gegensinnig rotierenden Rollen 10a, 10b besteht, zwischen denen ein Spalt mit der Dicke der Sootplatte 5a vorgesehen ist, und deren Oberflächen mit Längsprofilen versehen sind.

Die durch den Spalt hindurchlaufende Sootplatte 5a wird durch die Längsprofile der Rollen 10a, 10b in ungefähr gleich große Bruchstücke (Granulatteilchen 13) zerteilt, die in einem Auffangbehälter 11 gesammelt werden.

Zwischen der Trommel 1 und dem Brechwerkzeug 9 ist eine Trennwand 12 vorgesehen, die mit einer Öffnung zur Durchführung der Sootplatte 5a versehen ist und die zur Abschirmung des Sootabscheideprozesses von den Auswirkungen des Zerkleinerungsprozesses dient.

Bei einer alternativen Ausführungsform des erfindungsgemäßen Verfahrens ist anstelle der separaten Abscheidebrenner 4 ein Linearbrenner vorgesehen, der sich entlang der Rotationsachse 2 der Trommel 1 erstreckt.

Nach dem Abscheiden der Sootschicht mittels des Linearbrenners wird diese unmittelbar auch unter Einwirkung der Trommelbeheizung soweit gesintert, dass sich eine Sootdichte von 22 % (bezogen auf die Dichte von transparentem Quarzglas) einstellt.

Die nach dem Verfahren erhaltenen Granulatteilchen 13 haben eine plättchenartige oder flockenartige Morphologie und eine Dicke, die in etwa der Dicke der Sootplatte 5a entspricht, also etwa 45 µm. Infolge des beschriebenen Brechvorgangs sind auch die Granulatteilchen 13 in etwa gleich groß, so dass sich eine enge Korngrößenverteilung einstellt.

**Figur 2** zeigt schematisch ein derartiges nicht sphärisches, plättchenartiges SiO₂-Granulatteilchen 13 gemäß der Erfindung. Das Granulatteilchen 13 zeigt eine mehr oder weniger plane Oberseite 20 und eine parallel dazu verlaufende Unterseite 21 sowie seitliche Bruchflächen 22, jeweils mit offenen Poren. Die Dickenabmessung ist mit "c" bezeichnet und die beiden seitlichen Abmessungen mit "a" und "b". Das Strukturverhältnis "A", also das Verhältnis von größter Strukturbreite (a oder b) und Dicke (c) der Granulatteilchen 13 beträgt im Ausführungsbeispiel etwa 10.

Die so erzeugten Granulatteilchen 13 dienen als Templat für die Herstellung poröser Kohlenstoffflocken. Zu diesem Zweck werden sie mit fein gemahlenem Pechpulver im Volumenverhältnis 1,6:1 (Pech: Granulatteilchen) homogen miteinander vermischt und die Partikelmischung wird auf eine Temperatur von 300°C erhitzt.

Das niedrig viskose Pech umhüllt die kleinen SiO₂-Granulatteilchen 13 und dringt in die Poren ein und infiltriert diese. Das Verhältnis von Pech- und Granulatteilchenvolumen ist dabei so gewählt, dass das Pech die Poren soweit füllt, dass kein nennenswertes freies Porenvolumen mehr übrig bleibt und dabei nahezu vollständig in der freie Schmelze verbraucht wird.

Nach einer Infiltrationsdauer von 30 min wird die Temperatur auf 700 °C erhöht und das Pech dadurch carbonisiert. Es bildet sich eine poröse Kompositmasse aus nicht sphärischen porösen SiO₂-Granulatteilchen, die außen mit einer Lage aus graphitisierbarem Kohlenstoff belegt und deren Poren nahezu vollständig damit gefüllt sind.

Die SiO₂-Granulatteilchen werden anschließend entfernt, indem die Kompositmasse in ein Flusssäurebad eingebracht wird. Nach dem Wegätzen der SiO₂-Granulatteilchen wird ein Vorprodukt aus porösem Kohlenstoff erhalten, dessen Struktur im Wesentlichen ein Negativabdruck der ursprünglichen, porösen SiO₂-Granulatteilchen darstellt und eine hierarchische Porenstruktur aufweist, bei der eine Vielzahl relativ großer Porenkanäle (Makroporen) eine ansonsten feingliedrig zerklüftete Oberflächenstruktur durchziehen.

Das so erhaltene Kohlenstofferzeugnis wird gespült, getrocknet und bei Bedarf weiter zerkleinert. Es werden Kohlenstoffflocken erhalten, bei denen eine feingliedrig zerklüftete Oberfläche von größeren Hohlräumen kanalartig durchzogen ist. Eine Messung der spezifischen inneren Oberfläche nach der BET-Methode ergibt Messwerte um 50 m²/g.

Diese Kohlenstoffflocken aus porösem Kohlenstoff mit hierarchischer Porenstruktur eignen sich besonders gut für die Herstellung von Elektrodenschichten aufladbarer Lithium-Batterien, insbesondere für Kompositelektroden.

## Patentansprüche

1. Verfahren für die Herstellung poröser Granulatteilchen (13) aus anorganischem Werkstoff, umfassend die folgenden Verfahrensschritte:
(a) Zuführen eines Einsatzmaterial-Stroms zu einer Reaktionszone, in der das Einsatzmaterial durch Pyrolyse oder durch Hydrolyse zu Werkstoff-Partikeln umgesetzt wird,
(b) Abscheiden der Werkstoff-Partikel auf einer Ablagerungsfläche (1 a) unter Bildung einer Sootschicht (5),
(c) Thermisches Verfestigen der Sootschicht (5) zu einer porösen Sootplatte (5a),
(d) Zerkleinern der Sootplatte (5a) zu den porösen Granulatteilchen (13).

2. Verfahren nach Anspruch 1, **dadurch gekennzeichnet, dass** eine Sootplatte (5a) mit einer Dicke im Bereich von 10 bis 500 µm, vorzugsweise im Bereich von 20 bis 100 µm, besonders bevorzugt weniger als 50 µm erzeugt wird.

3. Verfahren nach Anspruch 1 oder 2, **dadurch gekennzeichnet, dass** das die Granulatteilchen (13) eine nicht sphärische Morphologie aufweisen.

4. Verfahren nach Anspruch 3, **dadurch gekennzeichnet, dass** die Granulatteilchen (13) plättchenförmig oder stäbchenförmig mit einem Strukturverhältnis von mindestens 5, vorzugsweise von mindestens 10 ausgebildet sind.

5. Verfahren nach Anspruch 4, **dadurch gekennzeichnet, dass** die Granulatteilchen (13) seitlich Bruchflächen (22) mit offenen Poren aufweisen.

6. Verfahren nach einem der vorhergehenden Ansprüche, **dadurch gekennzeichnet, dass** die Granulatteilchen (13) eine mittlere Dicke im Bereich von 10 µm bis 500 µm, vorzugsweise im Bereich von 20 µm bis 100 µm, besonders bevorzugt weniger als 50 µm aufweisen.

7. Verfahren nach einem der vorhergehenden Ansprüche, **dadurch gekennzeichnet, dass** die Ablagerungsfläche (1a) als Zylindermantelfläche einer um eine Rotationsachse (2) drehenden Trommel (1) ausgebildet ist.

8. Verfahren nach Anspruch 7, **dadurch gekennzeichnet, dass** die Sootschicht (5) nach weniger als einer Umdrehung der Trommel (1) um die Rotationsachse (2) ausgebildet ist.

9. Verfahren nach Anspruch 7 oder 8, **dadurch gekennzeichnet, dass** die Bildung der Sootschicht (5) mittels einer Anordnung (3) von Abscheidebrennern (4) erfolgt, die entlang der Rotationsachse (2) reversierend bewegt wird oder dass die Bildung der Sootschicht (5) mittels eines ortsfesten Linearbrenners erfolgt, dessen Längsachse sich entlang der Trommel (1) erstreckt.

10. Verfahren nach einem der vorhergehenden Ansprüche, **dadurch gekennzeichnet, dass** das thermische Verdichten der Sootschicht (5) gemäß Verfahrensschritt (c) ein Beheizen mittels mindestens eines Zusatzbrenners umfasst.

11. Verfahren nach einem der vorhergehenden Ansprüche, **dadurch gekennzeichnet, dass** die Ablagerungsfläche (1 a) auf einem Hohlkörper (11) ausgebildet ist, der von Innen temperiert wird.

12. Verfahren nach einem der vorhergehenden Ansprüche, **dadurch gekennzeichnet, dass** die Sootplatte (5a) eine relative Dichte - bezogen auf die spezifische Maximaldichte des Werkstoffs - im Bereich von 10 % bis 40 %, vorzugsweise weniger als 25%, aufweist.

13. Verfahren nach einem der vorhergehenden Ansprüche, **dadurch gekennzeichnet, dass** die Sootplatte (5a) zum Zerkleinern gemäß Verfahrensschritt (d) von der Ablagerungsfläche (1 a) abgenommen wird und dabei von der Unterseite der Sootplatte (5a) mit einem Gasstrom (7) angeblasen wird.

14. Verfahren nach einem der vorhergehenden Ansprüche, **dadurch gekennzeichnet, dass** das Zerkleinern der Sootplatte (5a) gemäß Verfahrensschritt (d) in einer Zone erfolgt, die von der Ablagerungsfläche (1 a) räumlich mindestens teilweise getrennt ist.

15. Verfahren nach einem der vorhergehenden Ansprüche, **dadurch gekennzeichnet, dass** das Zerkleinern der Sootplatte (5a) durch Brechen erfolgt.

## Claims

1. A method for producing porous granulate particles (13) of inorganic material, said method comprising the following method steps:
(a) feeding a streaming feedstock to a reaction zone in which the feedstock material is converted by pyrolysis or hydrolysis to particles of the inorganic material,'
(b) depositing the material particles on a deposition surface (1a) so as to form a soot layer (5),
(c) thermally consolidating the soot layer (5) into a porous soot plate (5a),
(d) comminuting the soot plate (5a) into the porous granulate particles (13).

2. The method according to claim 1, **characterized in that** a soot plate (5a) is produced with a thickness in the range of 10 µm to 500 µm, preferably in the range of 20 µm to 100 µm, particularly preferably less than 50 µm.

3. The method according to claim 1 or 2, **characterized in that** the granulate particles (13) have a non-spherical morphology.

4. The method according to claim 3, **characterized in that** the granulate particles (13) are plate- or rod-shaped with a structure ratio of at least 5, preferably of at least 10.

5. The method according to claim 4, **characterized in that** the granulate particles (13) are laterally provided with fracture surfaces (22) having open pores.

6. The method according to any one of the preceding claims, **characterized in that** the granulate particles (13) have a mean thickness in the range of 10 µm to 500 µm, preferably in the range of 20 µm to 100 µm, particularly preferably less than 50 µm.

7. The method according to any one of the preceding claims, **characterized in that** the deposition surface (1 a) is formed as an outer cylinder surface of a drum (11) rotating about a rotation axis (2).

8. The method according to claim 7, **characterized in that** the soot layer (5) is formed after less than one revolution of the drum (1) about the rotation axis (2).

9. The method according to claim 7 or 8, **characterized in that** the formation of the soot layer (5) is carried out using an assembly (3) of deposition burners (4) reversingly moving along the rotation axis (2), or that the formation of the soot layer (5) is carried out using a stationary linear burner having a longitudinal axis extending along the drum (1).

10. The method according to any one of the preceding claims, **characterized in that** the thermal consolidating of the soot layer (5) according to method step (c) includes heating with at least one additional burner.

11. The method according to any one of the preceding claims, **characterized in that** the deposition surface (1 a) is formed on a hollow body (11) which is temperature-controlled from the inside.

12. The method according to any one of the preceding claims, **characterized in that** the soot plate (5a) has a relative density, based on the specific maximum density of the material, in the range of 10% to 40%, preferably less than 25%.

13. The method according to any one of the preceding claims, **characterized in that** the soot plate (5a) is removed from the deposition surface (1a) for comminuting according to method step (d) while being blown at with a gas stream (7) from the bottom side of the soot plate (5a).

14. The method according to any one of the preceding claims, **characterized in that** said comminuting of the soot plate (5a) according to method step (d) is carried out in a zone that is separated in space at least in part from the deposition surface (1 a).

15. The method according to any one of the preceding claims, **characterized in that** said comminuting of the soot plate (5a) is carried out by crushing.

## Revendications

1. Procédé pour la fabrication de particules de granules poreux (13) à partir d'un matériau anorganique, comprenant les étapes suivantes de procédé :
(a) amenée d'un flux de matériau brut à une zone de réaction dans laquelle le matériau brut est transformé en particules par hydrolyse ou pyrolyse,
(b) précipitation des particules de matériau sur une surface de dépôt (1a) en formant une couche de suie (5),
(c) densification thermique de la couche de suie (5) en une plaque de suie poreuse (5a),
(d) broyage de la plaque de suie (5a) en particules de granulés poreux (13).

2. Procédé selon la revendication 1, **caractérisé en ce que** la plaque poreuse (5a) est produite avec une épaisseur comprise entre 10 µm et 500 µm, de préférence entre 20 µm à 100 µm, particulièrement inférieure à 50 µm.

3. Procédé selon la revendication 1 ou 2, **caractérisé en ce que** les particules de granulé (13) présentent une morphologie non sphérique.

4. Procédé selon la revendication 3, **caractérisé en ce que** les particules de granulé (13) sont en forme de plaque ou de petites barres sont réalisées avec un rapport de structure d'au moins 5, de préférence d'au moins 10.

5. Procédé selon la revendication 4, **caractérisé en ce que** les particules de granulés (13) présentent latéralement des surfaces de rupture (22) avec des ports ouvert.

6. Procédé selon l'une des revendications précédentes, **caractérisé en ce que** les particules de granulé (13) présentent une épaisseur comprise entre 10 µm et 500 µm, de préférence entre 20 µm à 100 µm, particulièrement inférieure à 50 µm.

7. Procédé selon l'une des revendications précédentes, **caractérisé en ce que** la surface de dépôt (1 a) sert d'enveloppe sphérique pour un tambour (1) tournant autour d'un axe de rotation (2).

8. Procédé selon la revendication 7, **caractérisé en ce que** la couche de suie (5) est formée après moins d'une rotation du tambour (1) autour de l'axe de rotation (2).

9. Procédé selon la revendication 7 ou 8, **caractérisé en ce que** la formation de la couche de suie (5) est effectuée au moyen d'un dispositif (3) de brûleurs de précipitation (4) qui est déplacé dans le sens inverse le long de l'axe de rotation (2), ou bien que la formation de la couche de suie (5) est effectuée au moyen d'un brûleur linéaire fixe dont l'axe longitudinal s'étend le long du tambour (1).

10. Procédé selon l'une des revendications précédentes, **caractérisé en ce que** la densification thermique de la couche de suie (5) selon l'étape de procédé (c) comprend le chauffage par au moins un brûleur supplémentaire.

11. Procédé selon l'une des revendications précédentes, **caractérisé en ce que** la surface de dépôt (1 a) est formée dans un corps creux (11) qui est surveillé en température depuis l'intérieur.

12. Procédé selon l'une des revendications précédentes, **caractérisé en ce que** la plaque de suie (5a) présente une densité relative - par rapport à la densité maximale spécifique du matériau, comprise entre 10% et 40%, de préférence inférieure à 25%.

13. Procédé selon l'une des revendications précédentes, **caractérisé en ce que** la plaque de suie (5a) est retirée de la surface de dépôt (1 a) pour être broyée selon l'étape de procédé (d) et la face inférieure de la plaque de suie (5a) est exposée à un courant de gaz (7).

14. Procédé selon l'une des revendications précédentes, **caractérisé en ce que** le broyage de la plaque de suie (5a) selon la méthode (d) s'effectue dans une zone, qui est séparée au moins partiellement de la surface de dépôt (d).

15. Procédé selon l'une des revendications précédentes, **caractérisé en ce que** le broyage de la plaque de suie (5a) est effectué par fragmentation.
